# EUROPEAN PATENT APPLICATION

(11) **EP 4 823 280 A1**
(43) Date of publication of application: **14.10.2026**
(21) Application number: 24900767.5
(22) Date of filing: 03.07.2024
(51) Int. Cl.: H10F 39/12, H10F 39/18

(54) **IMAGE SENSOR**

(30) Priority: 06.12.2023 KR 20230176018
(71) Applicant: LX Semicon Co., Ltd., Daejeon 34027 (KR)
(72) Inventor: OH, Nam Hoon, Daejeon 34027 (KR); KIM, Jong Man, Daejeon 34027 (KR)
(74) Representative: Ter Meer und Partner mbB
(86) International application number: PCT/KR2024/009427
(87) International publication number: WO 2025/121577

(57) **Abstract**

An image sensor is disclosed. An image sensor according to at least one of various embodiments of the present disclosure may include a lens unit configured to receive external light, and a pixel structure including a plurality of Backside Scattering Technology (BST) structures configured such that light passing through the lens unit is scattered, and a Deep Trench Isolation (DTI) structure disposed outside a BST structure disposed at an outermost side among the plurality of BST structures, and including a body portion including an Si substrate configured to absorb the light scattered through the plurality of BST structures and the DTI structure, wherein a length of the plurality of BST structures may be determined in consideration of a period indicating an interval between the BST structures.

## Description

### Technical Field

The present disclosure relates to an image sensor, and more particularly, to an image sensor in which at least one of quantum efficiency (QE) and optical efficiency (OE) is improved.

### Background Art

An image sensor refers to a device that reads information of an object and converts the information into an electrical image signal.

Such image sensors include various types such as a Charge Coupled Device (CCD) image sensor, a Complementary Metal Oxide Semiconductor (CMOS) image sensor, and a Near Infrared (NIR) image sensor.

In the above, the CCD image sensor and the CMOS image sensor are devices that detect light entering through a lens, particularly visible light, to generate an electrical signal, for example, an image (digital signal). The NIR image sensor is a device that detects light entering through a lens, particularly near infrared light, to generate an electrical signal (image).

Meanwhile, light incident through the lens of the image sensor undergoes refraction, reflection, scattering, and the like inside the image sensor after passing through the lens, and thus, in the image sensor, research on processing of the light incident through the lens is required in order to improve efficiency.

### Mode for Invention

### Technical Problem

At least one of various embodiments of the present disclosure is directed to providing an image sensor in which at least one of quantum efficiency (QE) and optical efficiency (OE) is improved.

At least one of various embodiments of the present disclosure is directed to providing various Backside Scattering Technology (BST) structures in order to improve efficiency of the image sensor.

Technical problems according to the present disclosure are not limited to those described in the present section, and include those that can be identified through the following description of the invention.

### Technical Solution

An image sensor according to at least one of various embodiments of the present disclosure may include a lens unit configured to receive external light, and a pixel structure including a plurality of Backside Scattering Technology (BST) structures configured such that light passing through the lens unit is scattered, and a Deep Trench Isolation (DTI) structure disposed outside a BST structure disposed at an outermost side among the plurality of BST structures, and including a body portion including an Si substrate configured to absorb the light scattered through the plurality of BST structures and the DTI structure, wherein a length of the plurality of BST structures may be determined in consideration of a period indicating an interval between the BST structures.

According to at least one of various embodiments of the present disclosure, among the plurality of BST structures, a first BST structure may be formed in a closed-loop structure to limit a scattering path of light entering through the lens unit.

According to at least one of various embodiments of the present disclosure, inside the first BST structure, at least one or more second BST structures among the plurality of BST structures may be formed.

According to at least one of various embodiments of the present disclosure, some of the second BST structures may be formed in a region including a center point of the pixel structure.

According to at least one of various embodiments of the present disclosure, remaining ones of the second BST structures may be formed to be disposed at positions having a predefined interval from the some formed in the region including the center point of the pixel structure.

According to at least one of various embodiments of the present disclosure, each BST structure may be formed in a peripheral region surrounding a center point of the pixel structure.

According to at least one of various embodiments of the present disclosure, each BST structure may be formed in a cubic shape.

According to at least one of various embodiments of the present disclosure, at least two or more surfaces of a cube forming each BST structure may overlap surfaces of another cube forming another BST structure.

According to at least one of various embodiments of the present disclosure, a width of each BST structure may be determined in consideration of refractive indices of a coating layer and the Si substrate.

According to at least one of various embodiments of the present disclosure, an interval between the BST structures may be determined in consideration of a diffraction effect of light entering through the lens unit, and an integer multiple of a wavelength sensed by a photo detector may be used.

### Advantageous Effects

According to at least one of various embodiments of the present disclosure,
first, there is an advantage in that an image sensor in which at least one of quantum efficiency and optical efficiency is improved can be provided, and
second, when light incident through a lens of the image sensor is scattered by the BST structures, there is an advantage in that an image sensor in which crosstalk resulting therefrom is minimized can be provided.

Technical effects of the embodiments are not limited to those described in the present section, and include those that can be identified through the description of the invention.

### Description of Drawings

FIG. 1 is a diagram illustrating a structure of a pixel included in an image sensor according to at least one of various embodiments of the present disclosure.
FIG. 2 is a diagram illustrating a method of manufacturing an image sensor according to at least one of various embodiments of the present disclosure.
FIGS. 3 and 4 are diagrams illustrating BST structures and DTI structures according to embodiments of the present disclosure.
FIG. 5 is a diagram illustrating an example of a detailed specification of a BST structure according to an embodiment of the present disclosure.
FIG. 6 is a diagram illustrating a scattering effect of a BST structure in relation to the present disclosure.
FIGS. 7 and 8 are diagrams illustrating characteristics or effects for each BST structure according to embodiments of the present disclosure.
FIGS. 9 and 10 are diagrams illustrating characteristics or effects for each DTI structure according to embodiments of the present disclosure.
FIG. 11 is a diagram illustrating optical efficiency of an image sensor according to an embodiment of the present disclosure.
FIG. 12 is a diagram illustrating a shape of a BST structure according to another embodiment of the present disclosure.
FIG. 13 is a diagram illustrating a potential difference in the BST structures of FIG. 12 including a case in which no BST structure is provided.
FIG. 14 is a diagram illustrating optical efficiency of an image sensor according to an embodiment of the present disclosure.

### Best Mode

Hereinafter, the invention according to embodiments for solving the above-described technical problems will be described in greater detail with reference to the drawings.

Suffixes "module" and "unit" for components used in the following description are assigned merely in consideration of ease of preparation of the present specification, and do not themselves have particularly important meanings or roles. Accordingly, the "module" and the "unit" may be used interchangeably with each other.

Terms including ordinal numbers such as first, second, and the like may be used to describe various components, but the components are not limited by the terms. The terms are used only for purposes of distinguishing one component from another component.

A singular expression includes a plural expression unless the context clearly indicates otherwise.

In the present application, terms such as "include", "have", or "may include" are intended to designate the presence of stated features, numbers, steps, operations, components, parts, or combinations thereof described in the specification, and should not be understood as precluding the presence or addition possibility of one or more other features, numbers, steps, operations, components, parts, or combinations thereof.

An image sensor according to various embodiments of the present disclosure is disclosed.

In this case, in the present specification, a Complementary Metal Oxide Semiconductor (CMOS) image sensor and a Near-Infrared (NIR) image sensor are described as examples of the image sensor. However, the present disclosure is not limited thereto.

Meanwhile, in the above, the NIR image sensor is exemplified as a sensor using a wavelength of 940 nm. However, the present disclosure is not limited thereto.

In particular, in the present specification, a method of improving at least one of quantum efficiency (QE) and optical efficiency (OE) of the image sensor according to various embodiments of the present disclosure is described using a pixel structure.

In this case, for convenience of description, the pixel structure is disclosed by taking one pixel as an example, but the present disclosure is not limited thereto.

The above-described method of improving efficiency of the image sensor may be determined according to, in particular, a Backside Scattering Technology (BST) structure, a Deep Trench Isolation (DTI) structure, and the like in the pixel structure, and thus, the present specification mainly describes contents related thereto. Accordingly, although included in the drawings, portions not described in detail or omitted may refer to known technologies.

In addition, the pixel structure included in the image sensor according to the present disclosure is exemplified as a structure including a micro lens array (MLA) in relation to a scattering effect according to the BST/DTI structures, but is not necessarily limited thereto.

In other words, the image sensor according to the present disclosure is intended to maximize a scattering effect through the BST/DTI structures while simultaneously minimizing crosstalk caused by such scattering. For this purpose, in the case of BST/DTI structures employed in conventional image sensors, there have been problems in that efficiency is reduced or crosstalk occurs, and the present specification proposes a solution thereto.

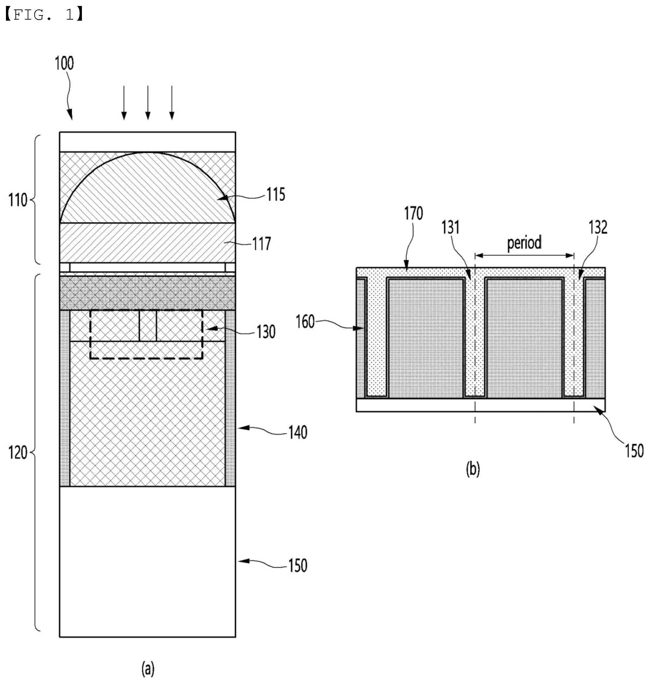

FIG. 1 is a diagram illustrating a structure of a pixel included in an image sensor according to at least one of various embodiments of the present disclosure.

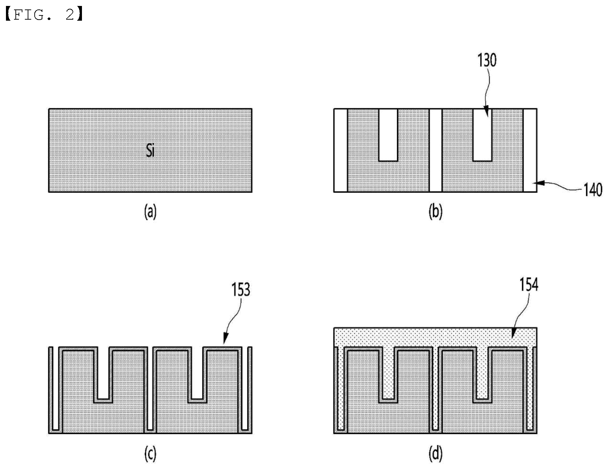

FIG. 2 is a diagram illustrating a method of manufacturing an image sensor according to at least one of various embodiments of the present disclosure.

An image sensor according to at least one of various embodiments of the present disclosure may include a lens unit configured to receive external light, and a pixel structure including a plurality of BST structures configured such that light passing through the lens unit is scattered, and a DTI structure disposed outside a BST structure disposed at an outermost side among the plurality of BST structures, and including a body portion including an Si substrate configured to absorb the light scattered through the plurality of BST structures and the DTI structure, wherein a length of the plurality of BST structures may be determined in consideration of a period indicating an interval between the BST structures.

(a) of FIG. 1 is a side cross-sectional view of a structure of one pixel 100 included in the image sensor, and (b) of FIG. 1 is an enlarged side cross-sectional view of a portion including a BST structure in the side cross-sectional view of (a) of FIG. 1.

Here, the pixel structure illustrated in (a) of FIG. 1 is, for example, one example of the pixel structure of the above-described NIR image sensor.

First, referring to (a) of FIG. 1, the pixel 100 included in the image sensor may be formed in a multi-layer structure.

A first layer 110 receives external light. In this case, the external light may enter a second layer 120 through a lens 115.

As described above, the lens 115 included in the first layer 110 is preferably a micro lens or a micro lens array (MLA) in consideration of the scattering effect. However, the present disclosure is not limited thereto.

Meanwhile, below the lens 115 of the first layer 110, at least one or more of, for example, an optical flat layer, a color filter, and metal grids disposed between pixels on both side surfaces of the color filter may be further included.

Next, the second layer 120 is a layer in which light received through the first layer 110 propagates. Meanwhile, information may be obtained from the propagating light in the second layer 120.

The second layer 120 may be formed from an Si body.

However, for convenience of description, the Si body may be divided into a region in which light propagates, that is, a region in which the BST structures and the DTI structures are formed (hereinafter referred to as a "second-1 layer" for convenience of description), and another region, that is, an Si substrate region (hereinafter referred to as a "second-2 layer" for convenience of description).

In the second-1 layer, at least one or more of reflection, absorption, and scattering may occur while light propagates through the BST structures and the DTI structures.

In particular, in relation to the present disclosure, among characteristics in a propagation process of light, characteristics related to scattering are mainly described.

For example, in the image sensor, as incident light is scattered more, acquisition of information from the received light may become more advantageous or more information may be obtained. Therefore, in the second-1 layer, it is preferable to form a structure in which the received light can be scattered more.

Such scattering characteristics of light may be mainly determined by or related to the BST structures 130 and the DTI structures 140 in the image sensor 100.

In (b) of FIG. 1, an enlarged cross-sectional view of a dotted-line box portion 125 indicated in the second layer 120 illustrated in (a) of FIG. 1 is illustrated.

A more detailed description of the BST structures 130 and the DTI structures 140 will be provided later, and first, a method of forming the BST structures 130 and the DTI structures 140 from the Si body will be described as follows.

(a) to (d) of FIG. 2 illustrate processes for forming the BST structures 130 and the DTI structures 140.

In this case, each process of (a) to (d) of FIG. 2 is preferably sequentially performed. However, the present disclosure is not necessarily limited thereto.

The BST structure may include a groove to provide a path through which light received through the lens 115 of the first layer may move. In the second layer 120, a silicon oxide-based material may be coated on such a movement path of the light. However, in the above, the present disclosure is not limited only to the silicon oxide-based material.

Referring to (b) of FIG. 1, the BST structure or groove according to an embodiment of the present disclosure may be formed in a rectangular shape.

According to another embodiment, although not illustrated, the BST structure or groove may also be formed in a polygonal structure or a geometrical structure other than a rectangular shape. For example, the BST structure or groove may be formed such that an upper surface is wide and a lower surface is narrow and has a predetermined inclination.

Al₂O₃ may be coated on an upper surface of the BST structure. In this case, the Al₂O₃ has electrical insulation properties such that, for example, light passing through the silicon oxide-based material is not absorbed by the BST structure and reflection or scattering is well performed. However, the present disclosure is not limited to Al₂O₃ as a material coated on the upper surface of the BST structure.

The BST structures and the DTI structures according to various embodiments of the present disclosure will be described later.

Finally, a third layer 130 includes an Si layer.

The Si layer may include a substrate. Various elements may be included in the substrate. Accordingly, in the Si layer, various types of information may be extracted and processed from light that is received through the lens 115 of the first layer, scattered through the second layer 120, and reaches the Si layer.

Hereinafter, each process of (a) to (d) of FIG. 2 related to formation of the BST structures 130 and the DTI structures 140 will be described as follows. However, in the present specification, only core contents for each process are described, and remaining contents may refer to known technologies.

First, referring to (a) of FIG. 2, an Si body is formed on an Si wafer through a bonding process, and the formed Si body is thinned through a thinning process using methods such as slicing and grinding.

Next, referring to (b) of FIG. 2, the BST structures 130 and the DTI structures 140 are formed.

In this case, formation of the BST structures 130 and the DTI structures 140 may be simultaneously or sequentially performed.

Meanwhile, the BST structures 130 and the DTI structures 140 may each be formed through an etching process on the Si body.

More specifically, the DTI structures 140 may each be formed on both side surfaces of the pixel structure 100 by sequentially performing a DTI photo process, an etching process, and a photo register strip process.

In the above, the photo process may indicate a photopatterning process using a predefined mask pattern related to the DTI structures 140. The etching process is a process of etching to form the DTI structures 140 using photopatterning formed on the Si body. The photo register strip process is a process of removing a photo register used in a previous process.

According to an embodiment, as illustrated in (b) of FIG. 2, when a plurality of BST structures 130 are provided, DTI structures 140 may be further formed between the BST structures.

Similar to the DTI structures 140, the BST structures 130 may also be formed in the pixel structure 100 by performing a BST photo process, an etching process, and a photo register strip process.

According to embodiments, a plurality of BST structures 130 may be formed.

The plurality of BST structures may be arranged at predetermined intervals.

In this case, the BST structures 130 are preferably formed to be disposed between the DTI structures formed on both side surfaces of the pixel structure 100.

Next, referring to (c) of FIG. 2, a process of depositing a first material 153 may be performed on the BST structures 130 and the DTI structures 140 formed on the Si body through the process illustrated in (b) of FIG. 2.

In the above, the first material 153 may include, for example, the above-described Al₂O₃. However, the first material 153 according to the present disclosure is not limited to Al₂O₃.

Finally, referring to (d) of FIG. 2, when a predetermined material is deposited on the Si body through the process illustrated in (c) of FIG. 2, a process of depositing a second material 154 may be performed.

In the above, the second material 154 may include silicon oxide 154. However, the second material 154 according to the present disclosure is not limited to silicon oxide.

Through the above-described processes of (a) to (d) of FIG. 2, the BST structures 130 and the DTI structures 140 are formed on the Si body in the pixel structure.

Meanwhile, various example BST structures and DTI structures described later may also be formed through the above-described processes of FIG. 2. Accordingly, process descriptions related to formation of each BST structure and DTI structure described later refer to the above-described contents, and repetitive descriptions thereof will be omitted in advance.

Referring again to the example illustrated in (b) of FIG. 1, a plurality of BST structures 131 and 132 may be formed on the Si substrate 150.

In this case, an interval between each BST structure and another BST structure may be defined as a period. In the above, the interval may indicate, for example, a distance between a center point of one BST structure and a center point of another adjacent BST structure. However, the definition of the interval is not limited only to the above-described definition, and may be defined in another manner.

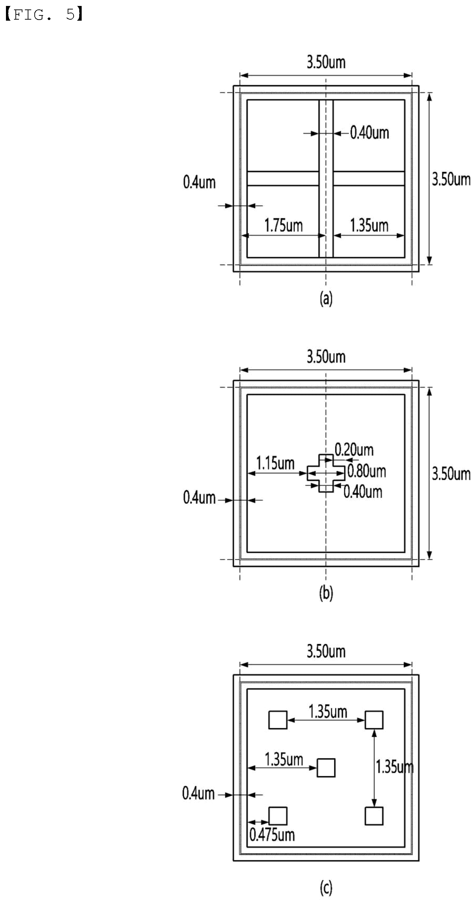

Detailed specifications of the BST structures will be described later with reference to FIG. 5.

First, hereinafter, various examples of BST structures according to embodiments of the present disclosure will be disclosed.

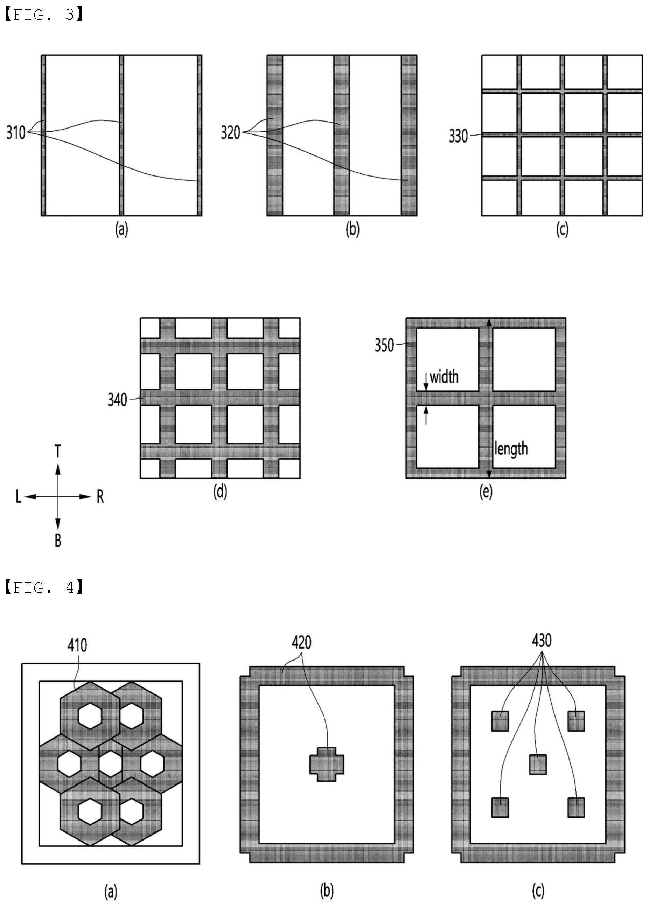

FIGS. 3 and 4 are diagrams illustrating BST structures and DTI structures according to embodiments of the present disclosure.

FIGS. 3 and 4 each illustrate a cross-sectional top-view of examples of BST structures of a pixel structure.

In this case, in order to describe the BST structures more easily, in FIGS. 3 and 4, each pixel structure including the BST structures is exemplified in a polygonal shape (for example, a quadrangular shape), but the present disclosure is not limited thereto.

In addition, for convenience of description, as illustrated in FIG. 3, an upper side of the quadrangular shape of the pixel structure is described as top (T), a corresponding lower side is described as bottom (B), a left side is described as left (L), and a corresponding right side is described as right (R). However, the present disclosure is not limited thereto.

Referring to (e) of FIG. 3, a width and a length of the BST structure are defined. For example, in FIGS. 5 to 14 described later, the width and the length may be arbitrary values as conditions for implementing optimal performance (OE) under a condition in which the lengths of the BST structures are the same, and may be changed as necessary. Accordingly, the present disclosure is not limited only to the corresponding values.

According to at least one of various embodiments of the present disclosure, among the plurality of BST structures, a first BST structure may be formed in a closed-loop structure to limit a scattering path of light entering through the lens unit.

According to at least one of various embodiments of the present disclosure, inside the first BST structure, at least one or more second BST structures among the plurality of BST structures may be formed.

According to at least one of various embodiments of the present disclosure, some of the second BST structures may be formed in a region including a center point of the pixel structure.

According to at least one of various embodiments of the present disclosure, remaining ones of the second BST structures may be formed to be disposed at positions having a predefined interval from the some formed in the region including the center point of the pixel structure.

Meanwhile, in FIGS. 3 and 4, it can be understood that the entire pixel structure illustrated in (a) of FIG. 1 is illustrated. For example, in FIGS. 3 and 4, the lens and the DTI structures are omitted for convenience of description. As one example, DTI structures may be formed outside edges of the quadrangular shape (for example, a left side of L and a right side of R) in each drawing of FIGS. 3 and 4. In this case, the formed DTI structures are preferably spaced apart from the BST structures by predefined intervals. However, the present disclosure is not limited thereto.

However, hereinafter, for convenience of description, the structures will be described as pixel structures.

First, in (a) of FIG. 3, a first BST structure 310 is illustrated. For convenience, the first BST structure 310 is referred to as a line structure, but is not limited to such a name.

A portion excluding the first BST structure 310 may indicate, for example, a second material, that is, silicon oxide. The same also applies to remaining (b) to (e) of FIG. 3 and (a) to (c) of FIG. 4.

In (b) of FIG. 3, a second BST structure 320 is illustrated. (b) of FIG. 3 may also be referred to as a line structure similarly to (a) of FIG. 3.

However, in order to distinguish the line-structure BST structures 310 and 320 illustrated in (a) and (b) of FIG. 3, the BST structures may be described as a first line-structure BST structure 310 and a second line-structure BST structure 320, respectively.

Referring to (a) and (b) of FIG. 3, it can be understood that three BST structures are formed in one pixel structure. Each BST structure may be formed in a line shape continuously extending from T to B. In this case, one BST structure may be disposed in a central region within the pixel structure, and remaining two BST structures may be respectively disposed in line shapes on side surfaces of the channel structure, that is, L and R.

However, a difference between (a) and (b) of FIG. 3 is that widths of the line-shape BST structures formed in (b) of FIG. 3 are wider than widths of the line-shape BST structures formed in (a) of FIG. 3.

Next, (c) to (e) of FIG. 3 may indicate pixel structures including BST structures 330, 340, and 350 formed in a type of lattice shape.

First, (c) and (d) of FIG. 3 have the same overall shape except that only widths of the BST structures formed in the pixel structures are different, similarly to (a) and (b) of FIG. 3.

On the other hand, in (e) of FIG. 3, although a lattice structure is provided, it can be understood that the BST structures are formed in a cross structure like a window.

For example, in the BST structure 350 formed in (e) of FIG. 3, BST structures are formed along all edges of the quadrangular shape, and furthermore, BST structures are also formed in directions from centers of the respective edges toward a center of the quadrangular shape. In this respect, the BST structure 350 formed in (e) of FIG. 3 is different from the BST structures 330 and 340 formed in (c) and (d) of FIG. 3.

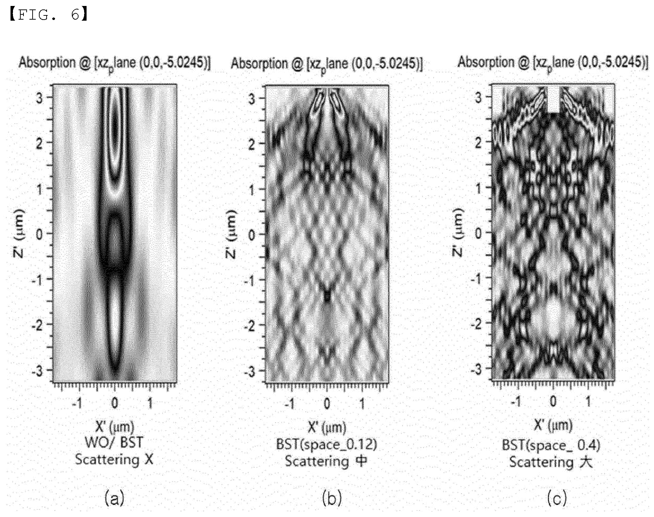

Meanwhile, it is important that each BST structure formed in the pixel structures illustrated in FIGS. 3 and 4 is not simply determined only based on a top-view, but how light incident through the lens 115 in the second layer 120 is scattered through the BST structures as described above and what effects occur therefrom are examined. This will be described later with reference to FIGS. 6 to 10.

(a) to (c) of FIG. 4 also illustrate shapes of BST structures formed in the pixel structures.

In the case of (a) of FIG. 4, it can be understood that a BST structure 410 is formed in the pixel structure in a shape like a beehive (that is, honeycomb). In other words, a single hexagonal BST structure is arranged adjacent to another hexagonal BST structure such that at least a plurality of surfaces thereof contact each other, thereby forming an overall honeycomb shape.

On the other hand, in (b) and (c) of FIG. 4, similarly to (e) of FIG. 3, BST structures are formed along all edges.

In the case of (b) of FIG. 4, a BST structure 420 may be expressed as a split shape because the BST structure 420 is largely divided into two BST structures, for example, BST structures formed along all edges and in a central region. In this case, in order to distinguish the split-shape BST structure 420 of (b) of FIG. 4 from the BST structure 430 of (c) of FIG. 4 described later, the split-shape BST structure 420 of (b) of FIG. 4 may be referred to as a first split-shape BST structure.

Meanwhile, each BST structure of (b) of FIG. 4 may have a cross shape.

On the other hand, also in the case of (c) of FIG. 4, the BST structure 430 has a form in which BST structures are respectively formed along edges and in an internal region similarly to the case of (b) of FIG. 4. However, in the case of (b) of FIG. 4, only one BST structure 420 is formed in the central region, whereas in (c) of FIG. 4, it can be understood that a plurality of BST structures are formed inside including the central region. In addition, in (c) of FIG. 4, among the plurality of BST structures formed in the internal region, one BST structure may be disposed in the central region, and remaining BST structures may be formed to face each other while having predetermined intervals. In this case, the predetermined intervals may be identical intervals.

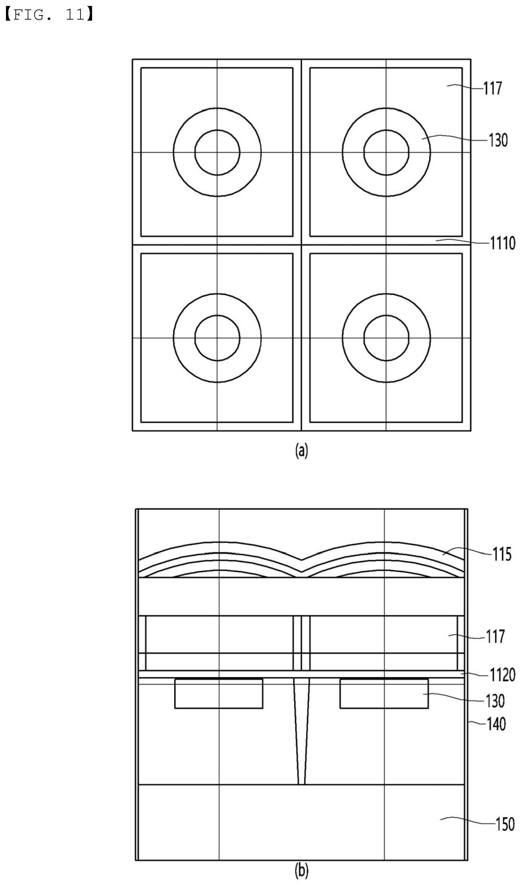

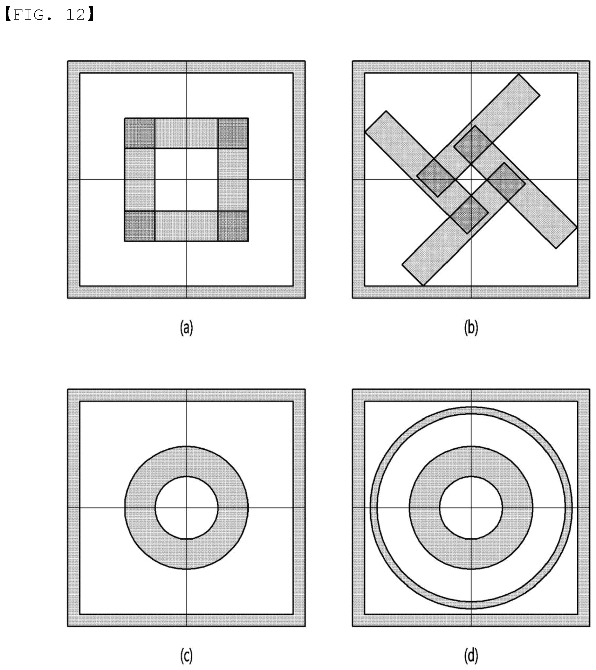

Meanwhile, according to at least one of various embodiments of the present disclosure, each BST structure may also be formed in a peripheral region surrounding a center point of the pixel structure, as described later with reference to FIGS. 11 and 12.

According to at least one of various embodiments of the present disclosure, each BST structure may be formed in a cubic shape.

According to at least one of various embodiments of the present disclosure, at least two or more surfaces of a cube forming each BST structure may overlap surfaces of another cube forming another BST structure.

According to at least one of various embodiments of the present disclosure, a width of each BST structure may be determined in consideration of refractive indices of a coating layer and the Si substrate.

According to at least one of various embodiments of the present disclosure, an interval between the BST structures may be determined in consideration of a diffraction effect of light entering through the lens unit, and an integer multiple of a wavelength sensed by a photo detector may be used.

FIG. 5 is a diagram illustrating an arrangement relationship or detailed specifications of the above-described BST structures according to the present disclosure.

In order to secure yield of the process illustrated in FIG. 2, sizes of the BST structures according to the present disclosure may apply a single width and a single length. However, the present disclosure is not limited thereto.

In relation to the present disclosure, as described above, when the pixel structure of the image sensor includes a micro lens array (MLA), the BST structures may be disposed in a central region of a pixel corresponding to a focusing position. However, the present disclosure is not limited thereto. In this case, in the present disclosure, for example, in a case of an image sensor not including the micro lens array (MLA), since it is difficult to expect a scattering effect through the BST structures, a detailed description thereof is omitted. However, the present disclosure should not necessarily be interpreted as being limited thereby.

Meanwhile, in the present disclosure, in order to secure performance of the image sensor, it is preferable to secure an amount of light at a lower portion of the Si layer (for example, z is about 7.0 um). For example, in order for light incident into the pixel to be transferred into many electrons, it is preferable that optical power at the lower portion of the Si layer in which electrons are sensed is secured.

When a plurality of BST structures are formed in the pixel structure, intervals between the BST structures are preferably defined such that efficiency can be maximized in consideration of a diffraction effect. As one example, when 0 < BST_period < 3λ, the interval between the BST structures is preferably 1.15*(n*λ/2) > period > 0.85*(n*λ/2). In this case, (n * λ) may indicate, for example, an integer multiple of a wavelength λ sensed by a photo detector. This is because, for example, when the period deviates from the corresponding cycle due to a light interference phenomenon, such definition of the interval may cause reduction of optical power. However, the present disclosure is not limited thereto.

It is preferable that a width of the BST structure is determined in consideration of refractive indices of an AR coating layer (for example, a silicon oxide-based material and the like) and the Si layer. As one example, when 0 < BST_period < 3λ, the width of the BST structure is preferably 1.15*(n*λ/2) > BST_width > 0.85*(n*λ/2). When a thickness of the width of the BST structure deviates from the corresponding dimension, scattering may not effectively occur or optical power may be reduced due to a light interference phenomenon. However, the present disclosure is not limited thereto.

Meanwhile, it is preferable that a length of the BST structure is determined in consideration of the period. As one example, when 0 < BST_period < 3λ, the length of the BST structure is preferably 1.15*(n*λ/2) > BST_length > 0.85*(n*λ/2). This is because, for example, when the length of the BST structure is within the corresponding range, scattering can effectively occur and an area of the BST structure is minimized, thereby enabling securing of optical power. However, the present disclosure is not limited thereto.

In addition, in relation to the present disclosure, a length of the DTI structure may be determined in consideration of a depth of the Si layer. For example, the length of the DTI structure may satisfy DTI structure length > Si_layer_deep/2. However, the present disclosure is not limited thereto.

Hereinafter, arrangement and detailed specifications of BST structures according to specific embodiments will be described. In this case, definitions included in the specifications are described based on a center line of the BST structure. However, when this is not the case, separate standards will be described.

(a) of FIG. 5 illustrates the BST structure illustrated in (e) of FIG. 3, (b) of FIG. 5 illustrates the BST structure illustrated in (b) of FIG. 4, and (c) of FIG. 5 illustrates the BST structure illustrated in (c) of FIG. 4.

First, referring to (a) of FIG. 5, a cross-shape BST structure is illustrated.

As illustrated in (e) of FIG. 3 and (a) of FIG. 5, the pixel structure may be described by being divided into a first BST structure and a second BST structure.

Here, the first BST structure may indicate, for example, a BST structure disposed at an edge. On the other hand, the second BST structure extends from each edge through the central region to another opposite edge such that two BST structures cross each other.

Widths of the first BST structure and the second BST structure may each be, for example, 0.4 um. However, the present disclosure is not limited thereto.

Horizontal and vertical lengths of the first BST structure may each be, for example, 3.5 um. A horizontal length of the second BST structure may be, for example, 1.75 um. On the other hand, a length between the first BST structure and the second BST structure, that is, a width of the second material, may be, for example, 1.35 um.

According to another embodiment, a width of the first BST structure may be different from a width of the second BST structure. For example, the width of the first BST structure may be narrower than the width of the second BST structure, or vice versa.

Widths of the first BST structures at T and B and widths of the first BST structures at L and R may be identical. According to embodiments, the widths of the first BST structures at T and B and the widths of the first BST structures at L and R may be different.

Widths of the second BST structures formed between T-B and widths of the second BST structures formed between L-R may be identical. According to embodiments, the widths of the second BST structures formed between T-B and the widths of the second BST structures formed between L-R may be different. For example, the widths of the second BST structures formed between T-B may be wider than the widths of the second BST structures formed between L-R, or vice versa.

The second BST structures formed between T-B may be formed such that both ends thereof are spaced apart from and do not contact at least one BST structure among T and B.

The second BST structures formed between L-R may be formed such that at least one end among both ends thereof is spaced apart from and does not contact at least one BST structure among L and R.

In (a) of FIG. 5, although the second BST structures have a crossed shape passing through the central region based on a top-view, the present disclosure is not necessarily limited thereto. For example, at least one of the second BST structures may cross without passing through the central region. Alternatively, at least one of the second BST structures may form an angle with the first BST structure that is not perpendicular. Alternatively, the second BST structures may be formed to be parallel to each other or not to cross each other.

Next, specifications of the first split BST structure illustrated in (b) of FIG. 4 and (b) of FIG. 5 will be described.

Similar to the BST structure illustrated in (a) of FIG. 5, in the first split BST structure, the first BST structures are formed along entire edges, and the second BST structures are formed in the central region. In this case, unlike the BST structure illustrated in (a) of FIG. 5, the second BST structures are formed such that both ends thereof do not contact the edges.

As illustrated in (b) of FIG. 5, widths of the second BST structures are, for example, 0.4 um between T-B and 0.8 um between L-R. An interval between the BST structures formed between L-R and inner surfaces of the first BST structures disposed at the edges is, for example, about 1.15 um.

Finally, specifications of the second split BST structure illustrated in (c) of FIG. 4 and (c) of FIG. 5 will be described.

Similar to the BST structure illustrated in (a) of FIG. 5, in the second split BST structure, the first BST structures are formed along entire edges and the second BST structures are formed in an internal region. In this case, unlike (a) and (b) of FIG. 5, the second BST structures may include a plurality of BST structures disposed at positions spaced apart from each other by predetermined intervals.

One among the plurality of second BST structures may be disposed in the central region. In this case, a distance between one surface of the second BST structure disposed in the central region and an inner surface of the first BST structure disposed at the edge may be, for example, about 1.35 um.

Meanwhile, among the plurality of second BST structures, except for one BST structure disposed in the central region, all BST structures may be disposed in regions other than the central region. In this case, it can be understood that the second BST structures are disposed at identical intervals from each other. In addition, the second BST structures disposed in internal regions other than the central region may each be disposed at positions separated from the second BST structure disposed in the central region by identical distances. For example, the remaining second BST structures excluding the second BST structure disposed in the central region may be disposed at intervals of, for example, 1.35 um from each other. Among them, two are disposed at positions close to T, and remaining two are disposed at positions close to B. Meanwhile, a distance between outer surfaces of the second BST structures disposed in regions other than the central region and inner surfaces of the first BST structures may be, for example, about 0.475 um.

However, numerical values mentioned or described in the present disclosure are merely examples, and the present disclosure is not limited thereto. For example, the numerical values may be determined in consideration of scattering effects described later.

FIG. 6 is a diagram illustrating a scattering effect of the BST structures in relation to the present disclosure.

FIG. 6 is a diagram illustrating a degree of the scattering effect in order to explain a scattering effect in the second layer 120 of light passing through a lens described later.

For example, (a) of FIG. 6 illustrates a case in which scattering does not occur. (a) of FIG. 6 illustrates, for example, a case in which no BST structure is included in the pixel structure.

Next, (b) and (c) of FIG. 6 each illustrate cases in which scattering occurs. However, (b) of FIG. 6 illustrates a case in which scattering occurs at a relatively weak level, and (c) of FIG. 6 illustrates a case in which scattering occurs relatively strongly.

In relation to such relative degrees of scattering, for example, (b) of FIG. 6 illustrates a case in which an interval (space) between BST structures is, for example, about 0.12 um, and (c) of FIG. 6 illustrates a case in which an interval between BST structures is, for example, 0.4 um.

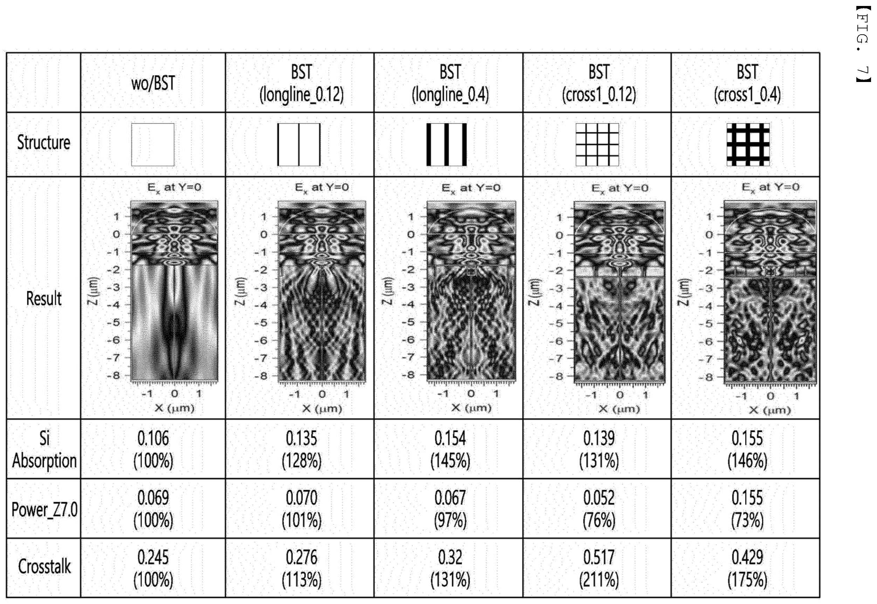

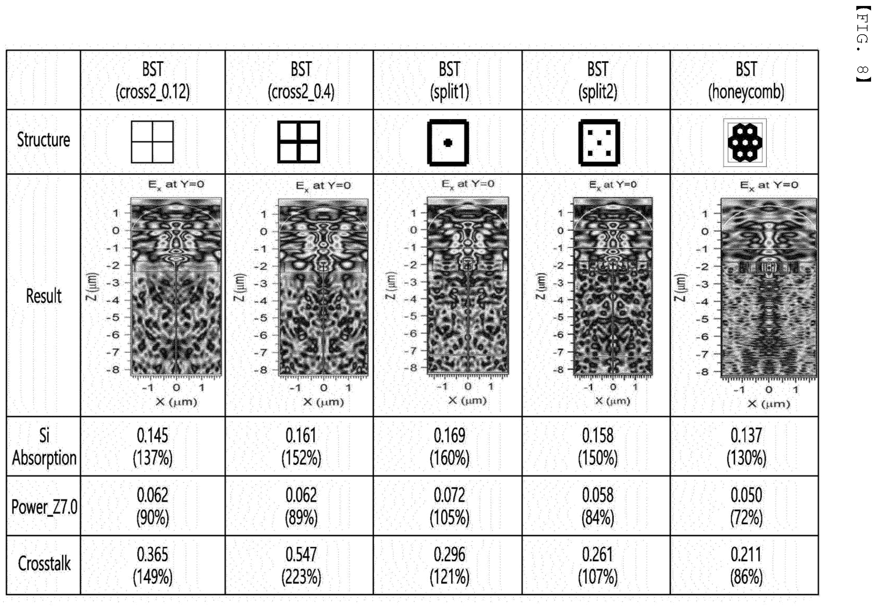

FIGS. 7 and 8 are diagrams illustrating characteristics or effects for each BST structure according to embodiments of the present disclosure.

Referring to FIG. 6, FIGS. 7 and 8 illustrate degrees of scattering for each BST structure exemplified in FIGS. 3 and 4 described above.

FIGS. 7 and 8 illustrate simulation results for scattering effects of respective BST structures.

In this case, the simulations are examples in which optical simulations are performed based on RCWA (Rigorous Coupled Wave Analysis)-based periodic structure simulation and an FDTD (Finite-Difference Time-Domain)-based method.

For convenience of description, FIGS. 7 and 8 will be continuously described together.

In tables illustrated in FIGS. 7 and 8, a horizontal axis (row) indicates each BST structure, and a vertical axis (column) sequentially indicates a structural shape, a simulation (scattering) result, Si absorption rate, power, and crosstalk.

Meanwhile, in FIGS. 7 and 8, it is assumed that inputs for the respective BST structures are identical. In addition, Si absorption rates, power consumption, and crosstalk of the respective BST structures may all be represented based on a case in which no BST structure is included in the pixel structure.

In particular, in FIG. 7, it can be understood that, for example, BST(cross1_0.12) has an Si absorption rate of 131%, power consumption of 76%, and crosstalk of 211% compared to a reference value (a case in which no BST structure is included).

In addition, in FIG. 7, it can be understood that, for example, BST(cross1_04) has an Si absorption rate of 146%, power consumption of 73%, and crosstalk of 175% compared to a reference value (a case in which no BST structure is included).

In the above-described two cases of FIG. 7, compared to the reference value, for example, the Si absorption rates are increased and the power consumption is also reduced, which is excellent, but a large amount of crosstalk occurs.

Meanwhile, referring to FIG. 8, it can be understood that, for example, in BST structure (split1), compared to the reference value, the Si absorption rate is increased to 160%, the power consumption is slightly increased to 105%, and the crosstalk is slightly increased to 121%.

On the other hand, it can be understood that, for example, in BST structure (split2), compared to the reference value, the Si absorption rate is increased to 150%, the power consumption is reduced to 84%, and the crosstalk is slightly increased to 107%.

Finally, it can be understood that, for example, in BST structure (honeycomb), compared to the reference value, the Si absorption rate is increased to 130%, the power consumption is reduced to 72%, and the crosstalk is reduced to 86%.

In summary, in the present disclosure, through various BST structures, control of Si absorption rate, power consumption, and crosstalk through scattering effects is intended.

For example, as described above, through the pixel structure in which the BST structures according to the present disclosure are applied, the Si absorption rate from incident light is intended to be increased as much as possible. A BST structure included in the pixel structure having the highest Si absorption rate may be BST(split1).

In addition, through the pixel structure in which the BST structures according to the present disclosure are applied, power consumed from incident light is intended to be reduced. BST structures included in the pixel structure in a case in which consumed power is significantly reduced may be BST(honeycomb), BST(cross1_0.4), and BST(cross1_0.12).

In addition, through the pixel structure in which the BST structures according to the present disclosure are applied, crosstalk from incident light is intended to occur less, that is, to be prevented. A BST structure included in the pixel structure in a case in which crosstalk is suppressed the most is BST(honeycomb).

According to another example, in the present disclosure, through the pixel structure in which the BST structures are applied, the Si absorption rate from incident light is intended to be increased while reducing consumed power.

In addition, in the present disclosure, through the pixel structure in which the BST structures are applied, consumed power from incident light is intended to be reduced while crosstalk is caused to occur less.

In addition, in the present disclosure, through the pixel structure in which the BST structures are applied, crosstalk from incident light is intended to be prevented while increasing the Si absorption rate.

According to another embodiment, in the present disclosure, through the pixel structure in which the BST structures are applied, the Si absorption rate from incident light is intended to be increased, consumed power is intended to be reduced, and crosstalk is simultaneously intended to be prevented.

In summary, in the various BST structures according to the present disclosure, in a case of total absorption of the Si layer (Layer Total Absorption), for example, about 50% or more additional absorption can be secured compared to a reference value, that is, a structure to which BST structures are not applied. This can contribute to improvement of sensitivity of the image sensor.

Meanwhile, optical power loss at a photon sensing position can be minimized. For example, in the BST structures according to the present disclosure, equal or better performance can be secured compared to structures to which BST structures are not applied.

In addition, crosstalk caused by scattering of the BST structures can also be reduced. This can also contribute to improvement of noise caused by crosstalk in structures to which DTI structures are not applied.

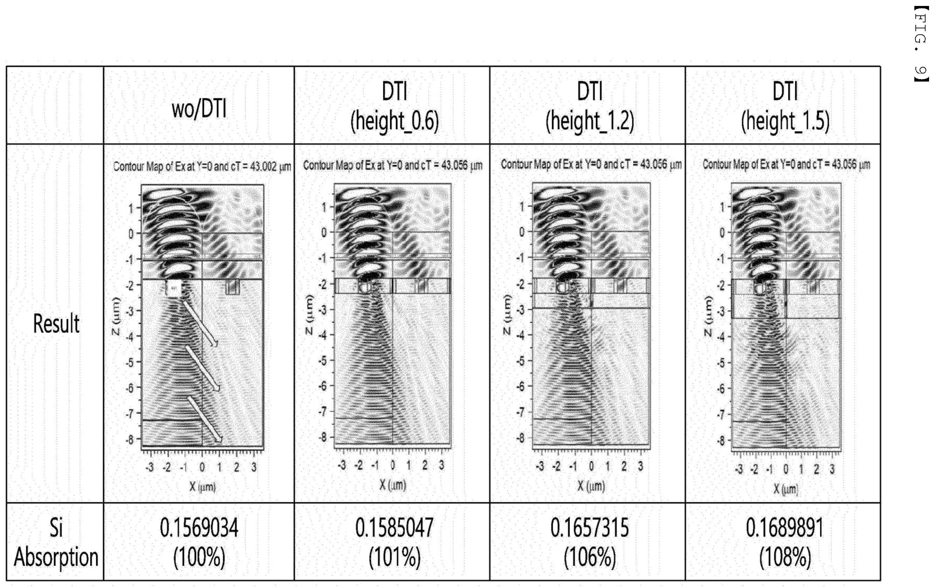

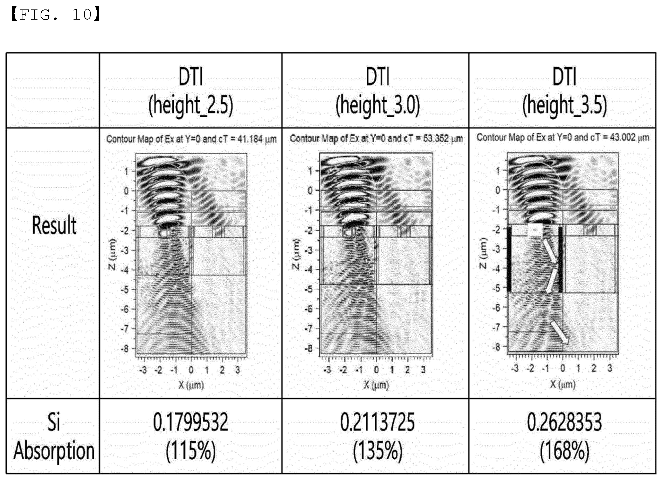

FIGS. 9 and 10 are diagrams illustrating characteristics or effects for each DTI structure according to embodiments of the present disclosure.

Simulation methods of FIGS. 9 and 10 are identical to those of FIGS. 8 and 9 described above, and thus basic contents related thereto will be omitted.

Unlike FIGS. 7 and 8, FIGS. 9 and 10 illustrate simulation results for Si absorption rates according to DTI structures.

A first column of FIG. 9 illustrates a simulation result for an Si absorption rate in a case in which no DTI structure is provided. This is described as a reference value for each DTI structure described later.

In FIGS. 9 and 10, it can be understood that the Si absorption rate increases as a height of the DTI structure increases in sequence.

Accordingly, referring to FIGS. 6 to 10, in consideration of at least one of increase of Si absorption rate, reduction of power consumption, and reduction of crosstalk, it is preferable that the height of the DTI structure is as large as possible and that a BST structure related to desired characteristics is selected and included in the pixel structure.

Meanwhile, in consideration of various circumstances such as process complexity, efficiency, and a purpose of the image sensor, it is preferable to determine a shape of the BST structure and a height of the DTI structure capable of achieving a maximum effect. Such determination process may be determined by an administrator, or may be determined based on a learning result when an artificial intelligence engine is included in a driver or a processor (a controller or including the same) driving the system.

Following the above-described improvement of quantum efficiency, a method of improving optical efficiency (OE) will hereinafter be disclosed.

In relation to such improvement of optical efficiency (OE), a CMOS image sensor is exemplified instead of the above-described NIR sensor for convenience, but the present disclosure is not limited thereto.

In the image sensor, optical efficiency (OE) may be calculated based on a trapped Poynting Vector (P unit: W/m-2) in a photo detector inside the pixel structure.

FIG. 11 is a diagram illustrating optical efficiency of an image sensor according to another embodiment of the present disclosure.

(a) of FIG. 11 illustrates a top-view of a pixel structure included in the image sensor, and (b) of FIG. 11 illustrates a side cross-sectional view.

Referring to (a) of FIG. 11, four pixels are included in the image sensor, and each pixel is distinguished from another pixel through a WRD grid, BST structures are formed in central regions of the respective pixels, and color filters are provided around the BST structures.

More specifically, referring to (b) of FIG. 11, it can be understood that a micro lens array, a color filter, an AR layer, BST structures and DTI structures, and an Si layer are formed sequentially from an uppermost side.

The pixel structure of the image sensor of FIG. 11 is similar to the above-described embodiment of the NIR sensor, but may differ in characteristics of the CMOS sensor.

Hereinafter, BST structures in the CMOS image sensor will also be disclosed. Hereinafter, differences from the above-described contents related to the NIR sensor will be mainly described, and portions not particularly mentioned are assumed to be identical.

(a) to (d) of FIG. 12 illustrate shapes of BST structures according to another embodiment.

First, in the BST structure illustrated in (a) of FIG. 12, for example, no BST structure is formed at a center point, but a BST structure having a predetermined width is formed in a shape surrounding the center point. Meanwhile, BST structures may also be formed at edges of (a) of FIG. 12. However, widths of the BST structures formed at the edges and widths of the BST structures formed in an internal region may be different from each other.

In the BST structure illustrated in (b) of FIG. 12, similarly to (a) of FIG. 12, a plurality of BST structures are formed around a center point such that the BST structures have different angle values (based on T, B, L, or R). In this case, one end of each BST structure may overlap a side surface of another BST structure. Such overlapping may indicate that the BST structures are formed at different heights in a vertical direction. Meanwhile, another end thereof may contact an inner surface of a BST structure formed at an edge.

The BST structure illustrated in (c) of FIG. 12 illustrates a circular BST structure rather than a polygonal (quadrangular) BST structure unlike (a) of FIG. 12.

Meanwhile, in the BST structure illustrated in (d) of FIG. 12, it can be understood that an additional BST structure having a larger diameter is further included outside the circular BST structure (based on a top-view) illustrated in (c) of FIG. 12. In this case, widths and diameters of the additional BST structure and the internal BST structure may be different from each other. In addition, as illustrated, the additional BST structure may not have an overlapping region with the internal BST structure or the BST structures formed at the edges. A diameter of the additional BST structure is preferably smaller than a horizontal or vertical length of the BST structures formed at the edges.

However, the present disclosure is not limited only to the BST structures illustrated in FIG. 12.

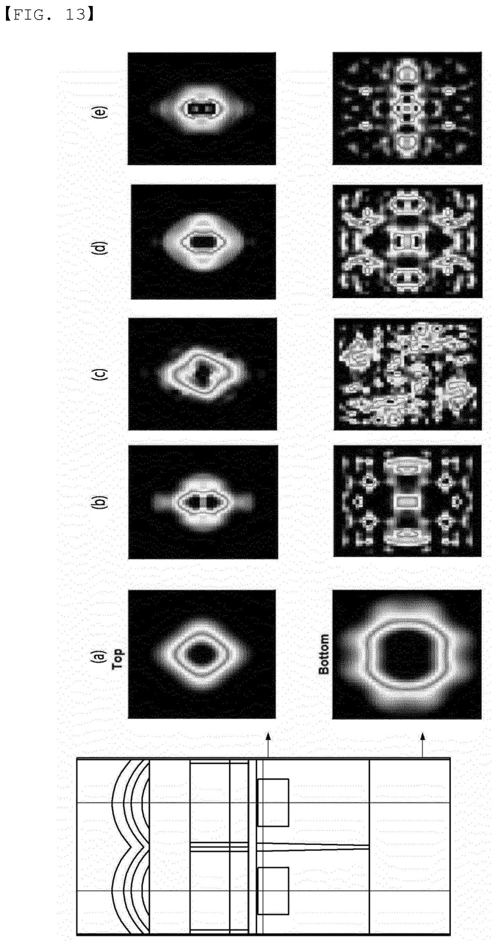

FIG. 13 is an image illustrating electrical potentials of the respective BST structures illustrated in (a) to (d) of FIG. 12, including a case in which no BST structure is provided.

In particular, (a) of FIG. 13 corresponds to a CMOS image sensor in which no BST structure is provided, and (b) to (e) of FIG. 13 respectively correspond to (a) to (d) of FIG. 12.

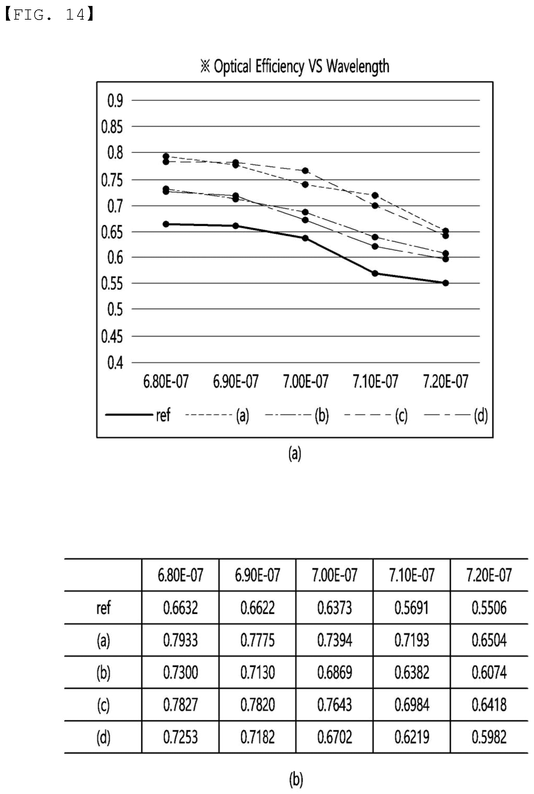

FIG. 14 is a diagram illustrating optical efficiency of an image sensor according to an embodiment of the present disclosure.

(a) of FIG. 14 is a graph illustrating simulation results for explaining optical efficiency (OE) of the image sensor according to shapes of BST structures included in the image sensor described above with reference to FIGS. 12 and 13, and (b) of FIG. 14 is a table illustrating simulation result values for the respective shapes of the BST structures illustrated in the graph of (a) of FIG. 14.

Meanwhile, in relation to optical efficiency of the Si substrate illustrated in (a) of FIG. 14, simulation for values of optical power variation is performed using, for example, Finite Difference Time Domain (FDTD) simulation.

In relation to the graph of (a) of FIG. 14 and the table of (b) of FIG. 14, in order to calculate variation values of optical power, for example, the following equations may be used.

Equation 1 illustrates a time-dependent Maxwell-Boltzmann equation required for calculating variation values of optical power according to the present disclosure.

[Equation 1]

Equation 2 illustrates a Poynting vector equation required for calculating variation values of $\frac{\partial E}{\partial t} = \frac{1}{ε} \left(∇\times H-J\right) , \frac{\partial H}{\partial t} = - \frac{1}{μ} \left(∇\times E\right)$ optical power according to the present disclosure.

[Equation 2]

Equation 3 illustrates an equation for calculating variation values of optical power according to $\vec{P} = \frac{1}{2} \left[\begin{matrix}\to \\ E\end{matrix}\times \begin{matrix}\to \\ H\end{matrix}\right]$ the present disclosure.

[Equation 3]

The image sensor according to the present disclosure described above may be applied to $OE = \frac{{\int }_{surfacephotodiode} {P}_{tot} ⋅ {n}_{surfacephotodiode} ds}{{\int }_{surfacetoppixel} {P}_{inc} ⋅ {n}_{surfacetoppixel} ds}$ various fields. For example, the image sensor according to the present disclosure may be directly applied, or applied through slight modifications easily understood by those skilled in the art, in order to improve efficiency of image sensors used in various fields such as automobiles, robots, industrial automation, eXtended Reality, and environmental monitoring.

Although embodiments of the present invention have been described above with reference to the present disclosure, those skilled in the art will readily understand that the present invention may be variously modified and changed without departing from the spirit and scope of the present invention set forth in the following claims.

### Industrial Applicability

The present disclosure relates to an image sensor, and particularly, quantum efficiency (QE) and/or optical efficiency (OE) can be improved through a pixel structure employing various BST/DTI structures in the image sensor, and thus the present disclosure is applicable to image sensors applied to various systems and has industrial applicability.

## Claims

1. An image sensor comprising:
a lens unit configured to receive external light; and
a pixel structure comprising:
a plurality of Backside Scattering Technology, BST, structures configured such that light passing through the lens unit is scattered; and
a Deep Trench Isolation, DTI, structure disposed outside a BST structure disposed at an outermost side among the plurality of BST structures,
wherein the pixel structure comprises a body portion including an Si substrate configured to absorb the light scattered by the plurality of BST structures and the DTI structure,
wherein a length of the plurality of BST structures is determined in consideration of a period indicating an interval between the BST structures.

2. The image sensor of claim 1, wherein, among the plurality of BST structures, a first BST structure is formed in a closed-loop structure to limit a scattering path of light entering through the lens unit.

3. The image sensor of claim 2, wherein at least one or more second BST structures among the plurality of BST structures are formed inside the first BST structure.

4. The image sensor of claim 3, wherein some of the second BST structures are formed in a region including a center point of the pixel structure.

5. The image sensor of claim 4, wherein remaining ones of the second BST structures are formed to be disposed at positions having predefined intervals from some of the second BST structure formed in the region including the center point of the pixel structure.

6. The image sensor of claim 1, wherein each BST structure is formed in a peripheral region surrounding a center point of the pixel structure.

7. The image sensor of claim 6, wherein each BST structure is formed in a cubic shape.

8. The image sensor of claim 7, wherein at least two or more surfaces of a cube forming each BST structure overlap surfaces of another cube forming another BST structure.

9. The image sensor of claim 1, wherein a width of each BST structure is determined in consideration of refractive indices of a coating layer and the Si substrate.

10. The image sensor of claim 1, wherein an interval between the BST structures is determined in consideration of a diffraction effect of light entering through the lens unit, and an integer multiple of a wavelength sensed by a photo detector is used.
